(19) Europäisches Patentamt / European Patent Office / Office européen des brevets

(11) **EP 3 001 879 B1**

(12) **EUROPEAN PATENT SPECIFICATION**

(45) Date of publication and mention of the grant of the patent:
**07.12.2016 Bulletin 2016/49**

(21) Application number: **14752407.8**

(22) Date of filing: **02.07.2014**

(51) Int Cl.:
*H01J 9/12* *(2006.01)*  *C23C 14/00* *(2006.01)*
*H01J 9/395* *(2006.01)*

(86) International application number:
**PCT/IB2014/062788**

(87) International publication number:
**WO 2015/004574 (15.01.2015 Gazette 2015/02)**

(54) **VERBESSERTER METALLDAMPFSPENDER**

VERBESSERTEE METALLDAMPFSPENDER

DISTRIBUTEUR DE VAPEUR DE MÉTAL AMÉLIORÉ

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **11.07.2013 IT MI20131171**

(43) Date of publication of application:
**06.04.2016 Bulletin 2016/14**

(73) Proprietor: **Saes Getters S.p.A.**
**20020 Lainate (MI) (IT)**

(72) Inventors:
- **DI GIAMPIETRO, Diego**
  **I-65122 Pescara (PE) (IT)**
- **BONUCCI, Antonio**
  **22589 Hamburg (DE)**
- **SANTELLA, Gianni**
  **I-67049 Tornimparte (AQ) (IT)**

(74) Representative: **Spina, Alessandro**
**Società Italiana Brevetti S.p.A.**
**Via Carducci, 8**
**20123 Milano (IT)**

(56) References cited:
**EP-A1- 1 967 605    WO-A1-2011/006811**
**GB-A- 1 274 528    US-A- 2 557 530**
**US-A- 4 112 290**

- **"Alkali Metal Dispenser", SAES getters , 20 April 2011 (2011-04-20), XP002720836, Retrieved from the Internet: URL:http://www.saesgetters.com/sites/defau lt/files/AMD%20Brochure_0.pdf [retrieved on 2014-02-20]**

EP 3 001 879 B1

**Description**

The present invention relates to improvements in heated metal dispensers, with particular reference to alkali metal vapour dispensers and more particularly to alkali metal vapour dispensers of a filiform type.

In the following and for the purposes of the present invention, the terms dispenser, generator and source are to be considered equivalent and indicate an object, a system and a device suitable to release metal vapours.

The metal vapour dispensers according to the present invention are capable to improve control on rate and reproducibility of the metal vapours therefrom.

Among the use of metal vapours, alkali metals play an increasingly critical role since they are used in various high-end manufacturing processes requiring a precise dosage and control in the released amounts, in particular lithium and caesium are used in the electronic field for the manufacturing of photo-sensitive surfaces, such as those of image intensifiers or photo-multiplying tubes. Another important use of lithium, in the form of alloys or salts, is in the manufacturing of battery elements. In addition to this, lithium is more and more employed in the manufacturing of OLED ("Organic Light Emitting Display").

Most of the development activity in this field was devoted to analysing suitable compounds for metal evaporation or to using suitable additives to improve their releasing properties, typically in terms of yield or releasing temperature. The US patent 3,945,949 e.g. discloses the use of an alkali metal alloyed with gold or silver. The European patent 0360316 discloses instead the use of "core-shell" solutions for alkali metal releasing. The US patent 3,579,459, in the applicant's name, discloses the use of caesium chromates as releasing compounds, while more environmentally friendly caesium releasing compounds and suitable dispensers structures are described in the US patent 6,753,648 in the applicant's name. Lithium releasing compounds and suitable dispensers structures are described in the US patent 7,625,505 in the applicant's name.

The US patent 4,195,891, in the applicant's name, discloses a standard alkali dispenser structure containing an alkali metal compound mixed with either boron or silicon The US patent 2,557,530 discloses a metal vapour dispenser comprising an elongated carbon filament with a centre section of small cross-sectional area containing a cavity in which material to be evaporated is placed.

None of the above references specifically addresses the problem of having an uniform temperature profile over the dispenser length.

The problem of dispensing high amounts of alkali metals and of ensuring an uniform temperature in the dispenser is described in US patent 7,842,194, in the applicant's name, which teaches the use of suitable thermal shields.

There still exists a need to improve temperature profiles in metal vapour filiform dispensers, without resorting to the use of additional members such as thermal shields that make the dispensers structure more complex, increase its size and costs, which is an object of the present invention. This problem is even more serious also considering that, differently from the high load type dispensers described in the above mentioned US patent 7,842,194, filiform dispensers are typically not reusable once exhausted.

This problem is solved by the present invention, that in a first aspect thereof consists in a metal vapour dispenser comprising a filiform element containing a metal dispensing material, said filiform element having an aperture along at least 80% of its length, the metal vapour dispenser also comprising two terminals arranged at the ends of the filiform element, wherein the filiform element has an electrical resistance Rw and a surface area Sw, and wherein the two terminals have an overall electrical resistance Rt and an overall surface area St, characterized in that electrical resistances and surfaces areas Rw, Sw, Rt, St have the following relationship:

$$(Rt/St)/(Rw/Sw) < 0.7$$

and in that the overall surface area St of the terminals is equal to or higher than 72 mm$^2$.

Preferably the overall surface area St of the terminals is not higher than 10 cm$^2$, and even more preferably equal to or less than 5 cm$^2$.

For the sake of clarity, the wording "overall surface area" St of the terminals indicates the whole radiant surface area of the terminals comprising both the upper and lower surface areas of the terminals faces, also taking into account the surface area of the connecting portions through which the terminals are fixed to the filiform element.

The invention will be further described with the help of the following figures wherein:

- Figure 1 is a top view of a semi-assembled metallic dispenser according to the prior art,
- Figures 2A-2E show top views of metallic dispenser terminals modified according to the present invention,
- Figure 3 shows a top view of a metallic dispenser according to the present invention with an indication of five temperature sampling points.

In the figures only the elements strictly necessary for illustrating the invention have been represented. Moreover, dimensions and dimensional ratios in some case have been altered in order to improve the figures readability.

A filiform element according to the present invention is an element presenting a dispensing aperture, typically in the form of a slit running along a substantial portion of its length, which is equal to or higher than 80%. The filiform element is defined as having a length-to-width ratio of at least 10. Typically such ratio is not higher than 1000. This ratio variability is due to the fact that metal dispensers according to the present invention may be used in different processes. Where thin layers or low concentration doping are required, low amounts of metal vapours need to be generated, whereas when thicker layers of metal vapours depositions are necessary, bigger (i.e. longer) filiform dispensers are required.

The width of the slit is typically comprised between 0.03 and 0.4 mm.

The purpose of the terminals arranged at the ends of the filiform element is to allow mounting and holding of the metal vapour dispenser, as well as heating by Joule effect due to current passage. The metal dispenser terminals have therefore also the function of current terminals in an electrical circuit.

The inventors have found that by a proper relationship between the surface area and resistivity of the filiform element and the surface area and resistivity of the terminals it is possible to improve the temperature profile along the dispenser, so as to achieve a more uniform and controlled dispensing of metal vapours as well a better exploitation of the material present inside the filiform element of the dispenser. Uniform temperature profiles improve the overall yield of metal material dispensing.

In particular, the ratio Rt/St between the overall electrical resistance and overall surface area of the terminals and the ratio Rw/Sw between the electrical resistance and surface area of the filiform element shall satisfy the following relationship:

$$(Rt/St)/(Rw/Sw) < 0.7$$

And more preferably:

$$(Rt/St)/(Rw/Sw) < 0.65$$

A standard metal dispenser, with particular reference to alkali metal vapour dispensers known in the art has an (Rt/St)/(Rw/Sw) ratio of 0.8.

It is important to underline that the above relation refers to values as measured, because the electrical resistance of an element may vary according to the material of which it is made, its cross sectional area and length. Hence, based on the relationship mentioned above and starting with a given body structure, electrical resistance and surface area, a person of ordinary skill in the art would immediately know how to size, choose and verify the terminals to be connected to a filiform element in order to manufacture a dispenser according to the present invention.

In this regards it also important to underline that in order to obtain a dispenser according to the present invention some modifications need to be made with respect to a standard dispenser. To this aim, the preferred solution envisions alteration of the Rt/St member of the relationship, since it is easier to act on the dispenser terminals rather than to modify a constitutional feature of the filiform element, which is the dispenser case for the metal material to be vaporized.

Even though it is in principle possible to make a dispenser according to the present invention by modifying the resistance value Rw of the material of which the filiform dispenser is made, e.g. by using a material with a lower resistance or a by employing a filiform element with a thinner wall, this is not preferred since any variation needs to be carefully balanced, for example an excessive decrease in the wall thickness of the filiform element would make its structure more fragile and difficult to handle.

With regards to the variation of the ratio Rt/St, i.e. when acting on the terminal features, this may be achieved by one or more of the following ways:

R1 Choosing a material with a higher resistivity.
R2 Coating on the terminals to increase their resistivity.
R3 Increasing the thickness of the terminals.
S1 Decreasing the surface area of the terminals by acting on their width and/or length.
S2 Decreasing the surface area of the terminals by cutting out one or more portions of a standard terminal, i.e. by using terminals whose shape is not rectangular. In this case the cuts are not made on the portions of the terminals connecting them to the filiform element.

The solution S2 is preferred, because it allows an easier integration of the metallic dispenser according to the invention in already existing equipment and devices, without requiring any modification thereof.

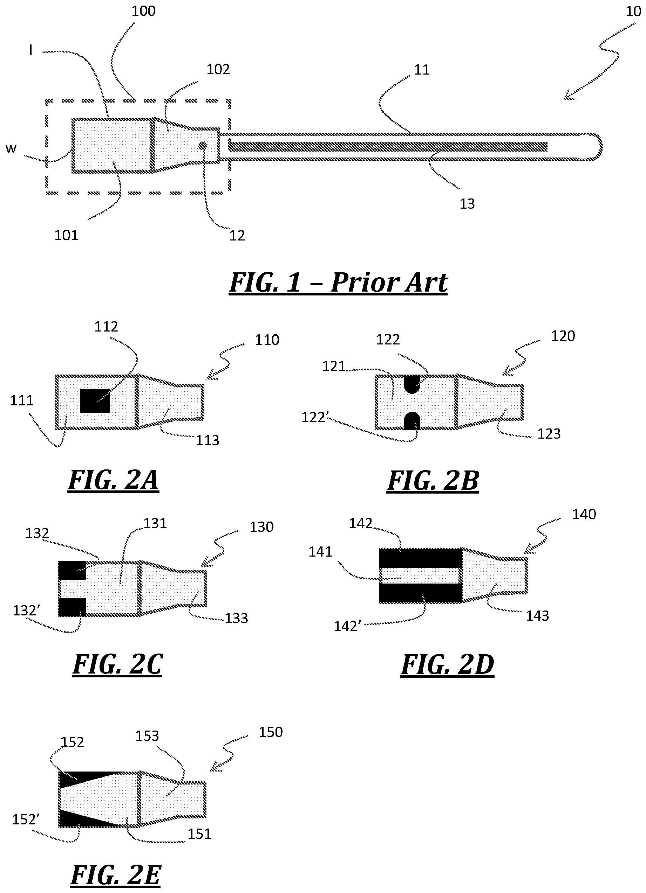

A typical standard width of a terminal (w in fig. 1) is 2.7 mm, and is strongly correlated to the filiform dispenser cross-section dimensions by the production process; a typical standard length of a terminal (*l* in fig. 1) is 9.5 mm, suitable for the most common electrical connection technologies. In order to decrease the terminal surface it is preferred to cut out a portion of the area comprised between 5% and 90%.

Figure 1 shows a top view of a semi-assembled metal vapour dispenser 10 according to the prior art, wherein a terminal 100 is mounted on the left end portion of a filiform element 11. The terminal 100 comprises a main portion 101 having a width w and a length *l* and a connecting portion 102, which has the purpose of allowing to insert and fix the terminal onto the filiform element 11. As shown in figure 1, the terminal 100 is fixed on the filiform element 11 by means of a soldering point 12. The connecting portion could be defined as the part of the terminal whose width varies from a dimension w to a dimension slightly larger than the width of the filiform element.

Modified terminals made according to the present invention are shown in figures 2A to 2E. In each of these figures one or more parts of the main portion 111; 121; 131; 141; 151 of the terminals 110; 120; 130; 140; 150 have been cut out. The surface area of the main portion of the terminal after the cut is therefore reduced with respect to the surface area of a standard terminal. In figures 2A to 2E the cut out portions 112; 122, 122'; 132, 132'; 142, 142'; 152, 152' are shown by way of solid hatching in black color. The connecting portions of the terminals 110; 120; 130; 140; 150 are indicated by reference numerals 113; 123; 133; 143; 153.

As already explained for the purposes of the present invention it is important that the surface area of the cut out portions is comprised between 5% and 90% of the surface area of the main portion of the terminals in order to achieve the desired condition on the parameter St. As previously specified the overall surface area St corresponds to the whole radiant surface area of both terminals, i.e. twice the surface area of the parts of the upper and lower faces of the main portions of the terminals remaining after the cut out operations plus the surface areas of the connecting portions of the terminals.

Suitable materials for the manufacturing of the filiform element and of the terminals of the dispenser are, for example, nickel alloys or nickel plated metals, among which preferred are Ni-Cr and Ni-Fe, Fe-Cr alloys such as the one sold under the trade name of FeCralloy, as well as steels such as the AISI 304L and AISI 316L. The materials used for the manufacturing of the terminals and of the filiform element may be the same or different. Once the materials and the geometric parameters of the terminals and of the filiform element have been chosen a person skilled in the readily knows how to obtain the required range for the (Rt/St)/(Rw/Sw) ratio.

The dispensers according to the present invention are preferably heated by making a current circulate through the connecting terminals at a temperature comprised between 300°C and 900°C. The current is usually comprised between 2 and 10 A.

Concerning suitable materials for dispensing metal vapours, any alloy or mix capable of dispensing metals at temperatures above 300°C, and preferably comprised between 350°C and 900°C may be used. The threshold temperature of 300°C ensures that the metal contained in the filiform element is not dispensed during undesired manufacturing steps, which would result in material losses in the form of metal vapours, also potentially leading to safety problems, while the upper threshold of 900°C ensures a good yield without resorting to excessive heating, which would otherwise require a higher amount of current as well as cause an increase in gases release by the metallic part of the dispenser structure.

In case of alkali metal, such as cesium or lithium, preferred is the use of molibdate, tungstate, niobate, tantalate, silicate and zirconate together with a reducing agent. These solutions are described in the above referenced patents US 6,753,648 and US 7,625,505. Other suitable and useful salts are titanate, chromate, permanganate. As disclosed in these patents, the preferred solution is to mix with a salt of the metal releasing compound a reducing element having also a getter function (i.e. a sorption function of undesired gases).

Suitable getter materials are for example, titanium, zirconium and alloys comprising titanium and/or zirconium and one or more transition element, wherein titanium and/or zirconium are at least 20% by weight of such alloys.

Typically, metal releasing materials are in the form of powders. When powders of different materials are present inside the filiform element, such as in the case of an alkali metal salt together with a getter material, these powders are usually mixed together and have a controlled grain size, e.g. lower than 1000 $\mu$m. The grain size of the powders is usually determined by means of a sieving operation.

**Example 1**

A series of metal vapour dispensers is made, each of them comprising a filiform element containing a mixture of cesium chromate and a ST101 getter with a weight ratio 1:5. The filiform element has a length of 2.5 cm, and comprises a slit whose width is 1.13 mm and whose length is 2.5 cm. The terminals are made of Ni-Cr in all the dispenser samples and have a thickness of 0.0095 mm. The surface area St of the terminals is varied according to the values shown in table 1, wherein the last column shows the (Rt/St)/(Rw/Sw) ratios. The surface area of the connecting portions of the terminals is instead constant and equal to 28.7 mm$^2$, because, as explained above, no cut-out operations are performed thereon.

In table 1 C1 indicates a metal dispenser made according to the prior art and therefore having a (Rt/St)/(Rw/Sw) value outside the scope of the present invention, while samples 1 to 3 are manufactured according to the present invention, and therefore their terminals have a reduced surface area with respect to the terminals of C1, which ensures that (Rt/St)/(Rw/Sw) is equal to or lower than 0.7. The terminals of sample 3 feature reduced length and width relative to a standard terminal, while the terminals of samples 1 and 2 feature cut outs as shown in figure 2C. The second column of table 1 contains the values of the upper and lower surface areas of single terminals. Therefore the overall surface area St used in the calculation is four times this value (two terminals, upper and lower surfaces) plus the connection area used to connect the terminals to the filiform element.

**Table 1**

| Sample ID | Reduced terminal surface area (mm$^2$) Area 101 | Area St | Terminal characteristics | (Rt/St)/(Rw/Sw) |
|---|---|---|---|---|
| 1 | 22.3 | 146.6 | Type 2C (solution A2) | 0.58 |
| 2 | 21.95 | 145.2 | Type 2C (solution A2) | 0.39 |
| 3 | 19.5 | 135.4 | Reduced width and length (solution A1) | 0.58 |
| C1 (comparative) | 24.84 | 156.8 | Flat | 0.8 |

## Example 2

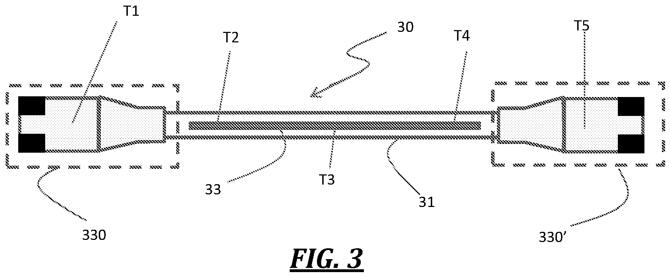

The metal vapour dispensers described in example 1 are then supplied with a current of 4.5 A for 200 seconds, and the temperature in different sections is measured according to the scheme shown in figure 3, that shows a metal dispenser 330 according to the present invention containing a filiform element 31 having a vapour releasing aperture or slit 33, and having terminals 330, 330' of the type shown in figure 2C. Figure 3 shows a total of five points/sections T1, T2, T3, T4, T5 wherein the temperature is measured, in particular at the terminals (points T1, T5), at portions of the filiform element close to the terminals (points T2, T4) and at a central portion of the filiform element (point T5). This measurement criteria is applied to all the metal vapour dispensers made according to what described in Example 1. The results of the measurements are shown in Table 2.

**Table 2**

| Sample ID | T1 | T2 | T3 | T4 | T5 | ΔTmax |
|---|---|---|---|---|---|---|
| 1 | 644 | 635 | 637 | 633 | 645 | 12 |
| 2 | 664 | 660 | 661 | 660 | 663 | 4 |
| 3 | 645 | 636 | 633 | 635 | 646 | 13 |
| C1 (comparative) | 595 | 625 | 631 | 627 | 616 | 36 |

On the basis of the results set forth in table 2, it is possible to observe that the metal vapour dispensers according to the present invention advantageously show and improved temperature uniformity over their length, as clearly indicated by the narrower maximum temperature difference (ΔTmax) of samples 1, 2 and 3 relative to the comparative sample C1. This results in a more controlled evaporation process and in a more efficient exploitation of the metal releasing compound, which provides costs advantages, as well as a more environmentally friendly production process, in particular in the case of alkali metal sources.

## Example 3

This example shows and emphasizes the unexpected effect of the cut-out in the embodiments shown in figures 2A-2E and 3. In particular the reduction of the surface area obtainable by cutting out a portion of the terminals leads to a higher variation in their electrical resistance. This explains why, contrary to what could be expected, the easiest way to decrease the Rt/St ratio, is to decrease the St value, as shown in table 3.

**Table 3**

| St(mm$^2$) | (Rt/St) (ohm/mm$^2$) |
|---|---|
| 156.8 | 3.78E-04 |
| 146.6 | 2.93E-04 |
| 145.2 | 1.91E-04 |
| 143.8 | 2.82E-04 |

Table 3 also shows that the Rt/St trend is not directly proportional to the reduction of the overall surface area St, hence to the size of the cut-out portion, and, even though decreasing, this trend may not be foreseen *a priori*.

**Claims**

1. A metal vapour dispenser (30) comprising a filiform element (31) containing a metal releasing material, said filiform element (31) having an aperture (33) on at least 80% of its length, the dispenser (30) further comprising two terminals (110; 120; 130; 140; 150; 330, 330') arranged at the ends of the filiform element (31), wherein said filiform element (31) has an electrical resistance Rw and a surface area Sw and wherein said two terminals (110; 120; 130; 140; 150; 330, 330') have an electrical resistance Rt and overall surface area St, **characterized by** the following relationship among the electrical resistances and surface areas Rw, Sw, Rt, St of the filiform element and of the terminals:

$$(Rt/St)/(Rw/Sw) < 0.7$$

and in that the overall surface area of the terminals St is equal to or higher than 72 mm$^2$.

2. A metal vapour dispenser (30) according to claim 1, wherein the relationship among the electrical resistances and surface areas Rw, Sw, Rt, St of the filiform element and of the terminals is: (Rt/St)/(Rw/Sw) < 0.65.

3. A metal vapour dispenser (30) according to any one of the previous claims, wherein the overall surface area (St) of the terminals is equal to or less than 5 cm$^2$.

4. A metal vapour dispenser (30) according to any one of the previous claims, wherein said filiform element (31) has length-to-width ratio comprised between 10 and 1000.

5. A metal vapour dispenser (30) according to any one of the previous claims, wherein the aperture (33) formed in the filiform element (31) has a width comprised between 0.03 and 0.4 mm.

6. A metal vapour dispenser (30) according to any one of the previous claims, wherein the terminals (110; 120; 130; 140; 150; 330, 330') have a main portion (111; 121; 131; 141; 151) wherein one or more cut-out portions (112; 122, 122'; 132, 132'; 142, 142'; 152,152') are formed.

7. A metal vapour dispenser (30) according to claim 6, wherein said cut out portions (112; 122, 122'; 132, 132'; 142, 142'; 152, 152') have a surface area comprised between 5% and 90% of the surface area of the main portions (111; 121; 131; 141; 151) of the terminals.

8. A metal vapour dispenser (30) according to any one of the previous claims, wherein the terminals (110; 120; 130; 140; 150; 330, 330') are made of nickel alloys, nickel plated metals, steels.

9. A metal vapour dispenser (30) according to any one of the previous claims, wherein said metal is an alkali metal, preferably chosen between lithium and cesium.

10. A metal vapour dispenser (30) according to claim 9, further containing at least one of an alkali metal molibdate, tungstate, niobate, tantalate, silicate, zirconate, chromate, permanganate, titanate together with a reducing agent.

11. A metal vapour dispenser (30) according to claim 10, wherein said reducing agent comprises one or more of titanium, zirconium and alloys comprising titanium and/or zirconium and one or more transition elements, with titanium and/or zirconium being at least 20 wt% of such alloys.

12. A metal vapour dispenser (30) according to any one of the previous claims, wherein the metal releasing material is in form of powders.

13. A metal vapour dispenser (30) according to claim 12, wherein said powders have a grain size equal to or less than 1000 μm.

**Patentansprüche**

1. Metalldampfspender (30), der ein filiformes Element (31) aufweist, das ein Metall freisetzendes Material enthält, wobei das genannte filiform Element (31) auf wenigstens 80 % seiner Länge eine Öffnung (33) hat, wobei der Spender (30) ferner zwei Endstücke (110; 120; 130; 140; 150; 330, 330') aufweist, die an den Enden des filiformen Elements (31) angeordnet sind, wobei das genannte filiforme Element (31) einen elektrischen Widerstand Rw und einen Flächeninhalt Sw hat und wobei die genannten zwei Endstücke (110; 120; 130; 140; 150; 330, 330') einen elektrischen Widerstand Rt und einen Gesamtflächeninhalt St haben, **gekennzeichnet durch** die folgende Beziehung unter den elektrischen Widerständen und Flächeninhalten Rw, Sw, Rt, St des filiformen Elements und der Endstücke:

$$(Rt/St)/(Rw/Sw) < 0{,}7$$

und **dadurch**, dass der Gesamtflächeninhalt der Endstücke St größer oder gleich 72 mm$^2$ ist.

2. Metalldampfspender (30) nach Anspruch 1, wobei die Beziehung unter den elektrischen Widerständen und Flächeninhalten Rw, Sw, Rt, St des filiformen Elements und der Endstücke wie folgt ist: (Rt/St)/(Rw/Sw) < 0,65.

3. Metalldampfspender (30) nach einem der vorhergehenden Ansprüche, wobei der Gesamtflächeninhalt (St) der Endstücke kleiner oder gleich 5 cm$^2$ ist.

4. Metalldampfspender (30) nach einem der vorhergehenden Ansprüche, wobei das genannte filiform Element (31) ein Verhältnis von Länge zu Breite zwischen 10 und 1000 hat.

5. Metalldampfspender (30) nach einem der vorhergehenden Ansprüche, wobei die in dem filiformen Element (31) ausgebildete Öffnung (33) eine Breite zwischen 0,03 und 0,4 mm hat.

6. Metalldampfspender (30) nach einem der vorhergehenden Ansprüche, wobei die Endstücke (110; 120; 130; 140; 150; 330; 330') einen Hauptteil (111; 121; 131; 141; 151) haben, in dem ein oder mehr ausgesparte Teile (112; 122, 122'; 132, 132'; 142, 142'; 152, 152') ausgebildet sind.

7. Metalldampfspender (30) nach Anspruch 6, wobei die genannten ausgesparten Teile (112; 122, 122'; 132, 132'; 142, 142'; 152, 152') einen Flächeninhalt zwischen 5 % und 90 % des Flächeninhalts der Hauptteile (111; 121; 131; 141; 151) der Endstücke haben.

8. Metalldampfspender (30) nach einem der vorhergehenden Ansprüche, wobei die Endstücke (110; 120; 130; 140; 150; 330, 330') aus Nickellegierungen, vernickelten Metallen, Stählen hergestellt sind.

9. Metalldampfspender (30) nach einem der vorhergehenden Ansprüche, wobei das genannte Metall ein Alkalimetall, vorzugsweise zwischen Lithium und Caesium ausgewählt, ist.

10. Metalldampfspender (30) nach Anspruch 9, der ferner wenigstens eines von einem Alkalimetall-Molibdat, -Wolframat, -Niobat, -Tantalat, -Silicat, -Zirkonat, -Chromat, - Permanganat, -Titanat zusammen mit einem Reduktionsmittel enthält.

**11.** Metalldampfspender (30) nach Anspruch 10, wobei das genannte Reduktionsmittel eine(s) oder mehr von Titan, Zirkonium und Titan und/oder Zirkonium aufweisenden Legierungen und ein oder mehr Übergangselemente aufweist, wobei Titan und/oder Zirkonium wenigstens 20 Gew.-% derartiger Legierungen sind.

**12.** Metalldampfspender (30) nach einem der vorhergehenden Ansprüche, wobei das Metall freisetzende Material die Form von Pulvern hat.

**13.** Metalldampfspender (30) nach Anspruch 12, wobei die genannten Pulver eine Korngröße von kleiner oder gleich 1000 $\mu$m haben.

**Revendications**

**1.** Distributeur de vapeur de métal (30) comprenant un élément filiforme (31) contenant une matière libérant du métal, ledit élément filiforme (31) ayant une ouverture (33) sur au moins 80 % de sa longueur, le distributeur (30) comprenant en outre deux bornes (110 ; 120 ; 130 ; 140 ; 150 ; 330, 330') disposées aux extrémités de l'élément filiforme (31), dans lequel ledit élément filiforme (31) possède une résistance électrique Rw et une aire surfacique Sw et dans lequel lesdites deux bornes (110 ; 120 ; 130 ; 140 ; 150 ; 330, 330') ont une résistance électrique Rt et une aire surfacique globale St, **caractérisé par** la relation suivante entre les résistances électriques et les aires surfaciques Rw, Sw, Rt, St de l'élément filiforme et des bornes :

$$(Rt/St)/(Rw/Sw) < 0,7$$

et dans lequel l'aire surfacique globale des bornes St est supérieure ou égale à 72 mm$^2$.

**2.** Distributeur de vapeur de métal (30) selon la revendication 1, dans lequel la relation entre les résistances électriques et les aires surfaciques Rw, Sw, Rt, St de l'élément filiforme et des bornes est : $(Rt/St)/(Rw/Sw) < 0,65$.

**3.** Distributeur de vapeur de métal (30) selon l'une quelconque des revendications précédentes, dans lequel l'aire surfacique globale (St) des bornes est inférieure ou égale à 5 cm$^2$.

**4.** Distributeur de vapeur de métal (30) selon l'une quelconque des revendications précédentes, dans lequel ledit élément filiforme (31) possède un rapport longueur sur largeur compris entre 10 et 1 000.

**5.** Distributeur de vapeur de métal (30) selon l'une quelconque des revendications précédentes, dans lequel l'ouverture (33) formée dans l'élément filiforme (31) possède une largeur comprise entre 0,03 et 0,4 mm.

**6.** Distributeur de vapeur de métal (30) selon l'une quelconque des revendications précédentes, dans lequel les bornes (110 ; 120 ; 130 ; 140 ; 150 ; 330, 330') possèdent une partie principale (111 ; 121 ; 131 ; 141 ; 151) dans laquelle sont formées une ou plusieurs parties échancrées (112 ; 122, 122' ; 132, 132' ; 142, 142' ; 152, 152').

**7.** Distributeur de vapeur de métal (30) selon la revendication 6, dans lequel lesdites parties échancrées (112; 122, 122' ; 132, 132' ; 142, 142' ; 152, 152') ont une aire surfacique comprise entre 5 % et 90 % de l'aire surfacique des parties principales (111 ; 121 ; 131 ; 141 ; 151) des bornes.

**8.** Distributeur de vapeur de métal (30) selon l'une quelconque des revendications précédentes, dans lequel les bornes (110 ; 120 ; 130 ; 140 ; 150 ; 330, 330') sont constituées d'alliages de nickel, de métaux plaqués de nickel, d'aciers.

**9.** Distributeur de vapeur de métal (30) selon l'une quelconque des revendications précédentes, dans lequel ledit métal est un métal alcalin, de préférence choisi entre le lithium et le césium.

**10.** Distributeur de vapeur de métal (30) selon la revendication 9, contenant en outre au moins un molybdate, tungstate, niobate, tantalate, silicate, zirconate, chromate, permanganate, titanate d'un métal alcalin conjointement avec un agent réducteur.

**11.** Distributeur de vapeur de métal (30) selon la revendication 10, dans lequel ledit agent réducteur comprend un ou plusieurs éléments parmi le titane, le zirconium et les alliages comprenant du titane et/ou du zirconium et un ou plusieurs éléments de transition, le titane et/ou le zirconium constituant au moins 20 % en poids de ces alliages.

12. Distributeur de vapeur de métal (30) selon l'une quelconque des revendications précédentes, dans lequel la matière libérant le métal est sous la forme de poudres.

13. Distributeur de vapeur de métal (30) selon la revendication 12, dans lequel lesdites poudres possèdent une taille de grain inférieure ou égale à 1 000 $\mu$m.

**FIG. 1 – Prior Art**

**FIG. 2A**

**FIG. 2B**

**FIG. 2C**

**FIG. 2D**

**FIG. 2E**

**FIG. 3**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 3945949 E
- US 0360316 A
- US 3579459 A
- US 6753648 B
- US 7625505 B
- US 4195891 A
- US 2557530 A
- US 7842194 B